# EUROPEAN PATENT APPLICATION

(11) **EP 1 249 302 A1**
(43) Date of publication of application: **16.10.2002**
(21) Application number: 00976358.2
(22) Date of filing: 20.11.2000
(51) Int. Cl.: B23K 35/26, H05K 3/34, B23K 1/00

(54) **SOLDER ALLOY, ELECTRONIC MEMBER HAVING SOLDER BALL AND SOLDER BUMP**

(30) Priority: 18.11.1999 JP 32849399; 06.07.2000 JP 2000205656
(71) Applicant: NIPPON STEEL CORPORATION, Tokyo 100-8071 (JP); Nippon Micrometal Corporation, Iruma-shi, Saitama 358-0032 (JP)
(72) Inventor: TANAKA, Masamoto, c/o Nippon Steel Corporation, Futtsu-shi, Chiba 293-0011 (JP); ENDO, Michio, c/o Nippon Steel Corporation, Futtsu-shi, Chiba 293-0011 (JP); HASHINO, Eiji, c/o Nippon Steel Corporation, Futtsu-shi, Chiba 293-0011 (JP); TATSUMI, Kohei, c/o Nippon Steel Corporation, Futtsu-shi, Chiba 293-0011 (JP); NAKAMORI, Takashi, c/o Nippon Micrometal Corp., Iruma-shi, Saitama 358-0032 (JP); FUJISHIMA, Masami, c/o Nippon Micrometal Corp., Iruma-shi, Saitama 358-0032 (JP)
(74) Representative: VOSSIUS & PARTNER
(86) International application number: JP0008163
(87) International publication number: WO01036148

(57) **Abstract**

A lead-free solder alloy is structured to contain 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower, and to have a smooth surface property after reflow. Further, an electronic member such as a semiconductor device is manufactured using the lead-free solder alloy. As a result, the solder alloy has an appropriate melting point and an excellent thermal fatigue resistant-characteristic, and can form an excellent surface property after solder reflow, so that the optical evaluation for bump formation can be made, and thus the solder alloy can be used as excellent material for a solder bump of an electronic member.

## Description

### Technical Field

The present invention relates to a lead-free solder alloy having a smooth surface property after reflow, and particularly to a solder alloy and a solder ball suitable for a solder bump on an electrode of an electronic member such as a semiconductor substrate or a printed board. The present invention further relates to an electronic member having a solder bump in which the solder alloy is used.

### Background Art

Recently, as an electronic part becomes more downsized and more densely packaged, a BGA (ball grid array) technique and a CSP (chip size package) technique have come in use when the electronic part is mounted on a printed wiring board or the like. Further, the size of an electrode applied in these techniques is becoming finer.

In joining the electrodes, solder bumps are first formed on a large number of electrodes arranged on a semiconductor substrate, electronic part, printed board, and the like. The solder bumps are formed on the electrodes on electronic members by putting solder balls on the electrodes using adhesion of flux and heating the electronic member to high temperature so that the solder balls are made to reflow. The semiconductor substrate or the like and the printed board or the like are joined with the solder bumps. It should be noted that the solder bump means a solder formed in a semi-spherical protrusion on a copper or plating electrode.

An electronic device, in which a semiconductor element and the electronic part are mounted on the substrate by the above-described mounting technique, is subjected to a thermal cycle of repeated heating and cooling where the temperature rises due to the heat generation of the semiconductor element itself when the device starts operation, and the temperature lowers due to the cooling of the semiconductor element when the device stops operation. Further, in some environments where the electronic device is used, the whole device may be put under the condition where high temperature and low temperature are repeated. When the semiconductor element itself generates heat, a thermal stress occurs to a joint between the semiconductor element and the printed board because temperature difference is caused between the semiconductor element and the printed board. In addition, when the whole device is subjected to the thermal cycle, a thermal stress also occurs in the joint between the semiconductor element and the printed board because of thermal expansion coefficient difference between the semiconductor element and the printed board. Since the semiconductor element and the printed board are joined with a solder electrode, if the strength and a thermal fatigue resistant characteristic of the solder electrode are small, a solder electrode portion is destroyed by the thermal stress. Therefore, an excellent thermal fatigue resistant characteristic is necessary for a solder alloy used in such joining.

Meanwhile, a lead-free solder alloy is demanded also as a solder alloy used in the electrode device in order to minimize impact on the environment in scrapping a discarded electronic device.

As the lead-free solder alloy, among binary alloys, the composition containing Sn and 3.5% Ag, which composes eutectic composition and has a relatively low melting point of 221°C, is generally used as a lead-free solder. It has an excellent thermal fatigue-resistant characteristic.

Further, among ternary alloys, as disclosed in Japanese Patent Laid-open No. Sho 63-13689, a solder alloy containing 0.05 to 3.0% (preferably 0.1 to 2.0%) Ag, 0.7 to 6.0% (preferably 2.0 to 4.0%) Cu, and the balance Sn is proposed as a solder alloy used for joining water pipes. The solder alloy proposed in this document has a characteristic that it is excellent in fluidity in a wide area and wettability to a metal. Its thermal fatigue-resistant characteristic is not referred to.

On the other hand, the solder alloy used for the electronic part should be excellent in thermal fatigue-resistant characteristic as described above. Disclosed in Japanese Patent Laid-open No. Hei 5-50286 is a high-temperature solder containing 3.0 to 5.0% Ag, 0.5 to 3.0% Cu, and the balance Sn, having an excellent thermal fatigue-resistant characteristic, as a lead-free solder alloy for an electronic device. As for the Ag content, it is described that although Ag has a great effect of improving the thermal fatigue-resistant characteristic, the effect of improving the thermal fatigue-resistant characteristic is not sufficient if the added amount is 3.0% or less. A melting point of the solder alloy proposed in the document is approximately 218°C. It is reported that, among Sn-Ag-Cu group solder alloys, 4.7% Ag - 1.7% Cu composes ternary eutectic composition, and the Ag content of 3.0% or higher brings the composition near an eutectic point, which lowers the melting point, so that usability as a solder alloy is realized.

In recent years, surface mounting and BGA mounting have been generalized in microelectronic devices such as a notebook PC, a video camera, a cellular phone, and the like, and an area of a substrate electrode pad is rapidly being downsized as the number of electrodes increases. Accordingly, an area of an individual electrode is becoming very small.

In a step of forming the solder bumps on the electrode of the substrate and the like, evaluation for confirming that excellent solder bumps have been formed on all of the large number of electrodes after reflow is needed. In general, light is irradiated to the electrode portions after solder reflow, the electrode portions are photographed with a camera, and image analysis is performed. In a case of an electrode on which a normal solder bump is formed, the semi-spherical solder bump which has been remelted and solidified has a smooth surface property so that an image of reflected light is observed in a manner of focusing on a top central part of the bump. In a case of an electrode on which the solder bump is not formed, it is plane and a focused light image is not observed so that the electrode can be recognized as a failed part.

When the solder alloy disclosed in the above-described Japanese Patent Laid-open Hei 5-50286, which is known as a solder alloy used for the electronic part, is used for forming a fine solder bump, the surface of the solder bump after reflow is rough and not smooth. Therefore, when the evaluation by the aforementioned image processing is performed, the image of reflected light does not focus on the top central part of the bump and the light image dispersed to the whole bump is obtained. This leads to the erroneous recognition as a bump formation failed part and correct evaluation cannot be performed.

Moreover, as the environment where the electronic member is used, cold climates need to be considered other than room temperature and high temperature. When the electronic member is used in the cold climates, heating and cooling from low temperature including sub-zero temperature up to high temperature are repeated. Accordingly, an excellent thermal fatigue-resistant characteristic capable of withstanding severe heating and cooling from the low temperature including the sub-zero temperature up to the high temperature is demanded of the solder alloy used for the electronic member utilized in such an environment.

Also in the lead-free solder alloy, in order to lower the reflow temperature at the time of forming the bump, a lower melting point is more preferable.

It is an object of the present invention to provide a solder alloy which is a lead-free solder alloy having an appropriate melting point, an excellent thermal fatigue-resistant characteristic, and an excellent surface property after solder reflow, and which is usable for a solder bump in an electronic member so that optical evaluation for bump formation can be performed, a solder ball having the composition, an electronic member having solder bumps of the composition, and a method for manufacturing (preparing) the same.

It is another object of the present invention to provide a solder alloy which is a lead-free solder alloy having an appropriate melting point, an excellent thermal fatigue-resistant characteristic capable of withstanding the use in cold climates, and an excellent surface property after solder reflow, and which is usable for a solder bump in an electronic member, so that optical evaluation for bump formation can be performed, a solder ball having the composition, an electronic member having solder bumps of the composition, and a method for manufacturing (preparing) the same.

### Summary of the Invention

The present invention is summarized as follows.

A lead-free solder alloy of the present invention comprises 2.0 to 3.0 wt% Ag, 0.3 to 1.5 wt% Cu, and the balance Sn and inevitable impurities, and has a smooth surface property after reflow.

A lead-free solder alloy of the present invention is a solder alloy for a solder bump of an electronic member, characterized in that it contains 2.0 to 3.0 wt% Ag, 0.3 to 1.5 wt% Cu, and the balance Sn and inevitable impurities.

A lead-free solder ball of the present invention comprises 2.0 to 3.0 wt% Ag, 0.3 to 1.5 wt% Cu, and the balance Sn and inevitable impurities.

An electronic member of the present invention is an electronic member having solder bumps, in which a part or all of the solder bumps are formed of lead-free solder alloys containing 2.0 to 3.0 wt% Ag, 0.3 to 1.5 wt% Cu, and the balance Sn and inevitable impurities.

An electronic member of the present invention is an electronic member in which plural electronic parts are joined with solder electrodes, in which a part or all of the solder electrodes are formed of lead-free solder alloys containing 2.0 to 3.0 wt% Ag, 0.3 to 1.5 wt% Cu, and the balance Sn and inevitable impurities.

In a method for preparing solder bumps of the present invention, a lead-free solder alloy containing 2.0 to 3.0 wt% Ag, 0.3 to 1.5 wt% Cu, and the balance Sn and inevitable impurities is used, and the lead-free solder alloy is subjected to reflow processing.

A method for manufacturing an electronic member of the present invention is a method for manufacturing an electronic member having solder bumps, in which the solder bumps are prepared using lead-free solder alloys containing 2.0 to 3.0 wt% Ag, 0.3 to 1.5 wt% Cu, and the balance Sn and inevitable impurities, by subjecting the lead-free solder alloy to reflow processing.

A method for manufacturing an electronic member of the present invention is a method for manufacturing an electronic member in which plural electronic parts are joined with solder electrodes, in which a part or all of the solder electrodes are formed of lead-free solder alloys containing 2.0 to 3.0 wt% Ag, 0.3 to 1.5 wt% Cu, and the balance Sn and inevitable impurities.

A lead-free solder alloy of the present invention comprises 2.0 to 3.0 wt% Ag, 0.3 to 1.5 wt% Cu, 0.05 to 1.5 wt% Bi, 0.2 to 1.5 wt% Sb, and the balance Sn and inevitable impurities, the total content of Ag, Cu, Sb, and Bi being 5.0 wt% or lower, and has a smooth surface property after reflow.

A lead-free solder alloy of the present invention is a solder alloy for a solder bump of an electronic member, characterized in that it contains 2.0 to 3.0 wt% Ag, 0.3 to 1.5 wt% Cu, 0.05 to 1.5 wt% Bi, 0.2 to 1.5 wt% Sb, and the balance Sn and inevitable impurities, and the total content of Ag, Cu, Sb, and Bi is 5.0 wt% or lower.

A lead-free solder ball of the present invention comprises 2.0 to 3.0 wt% Ag, 0.3 to 1.5 wt% Cu, 0.05 to 1.5 wt% Bi, 0.2 to 1.5 wt% Sb, and the balance Sn and inevitable impurities, and the total content of Ag, Cu, Sb, and Bi is 5.0 wt% or lower.

An electronic member of the present invention is an electronic member having solder bumps, in which a part or all of the solder bumps contain 2.0 to 3.0 wt% Ag, 0.3 to 1.5 wt% Cu, 0.05 to 1.5 wt% Bi, 0.2 to 1.5 wt% Sb, and the balance Sn and inevitable impurities, and the total content of Ag, Cu, Sb, and Bi is 5.0 wt% or lower.

An electronic member of the present invention is an electronic member in which plural electronic parts are joined with solder electrodes, in which a part or all of the solder electrodes are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, where the total content of Ag, Cu, Sb, and Bi is 5.0 wt% or lower.

In a method for preparing a solder bump of the present invention, a lead-free solder alloy containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower, is used, and the lead-free solder alloy is subjected to reflow processing.

A method for manufacturing an electronic member of the present invention is a method for manufacturing an electronic member having solder bumps, in which a part or all of the solder bumps are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower.

A method for manufacturing an electronic member of the present invention is a method for manufacturing an electronic member in which plural electronic parts are joined with solder electrodes, in which a part or all of the solder electrodes are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities in which the total content of Ag, Cu, Sb, and Bi is 5.0 wt% or lower.

When the solder alloy for the electronic part which is disclosed in Japanese Paten Laid-open No. Hei 5-50286 is used, the bump surface becomes rough. As a result of studies by the inventors, it has been clarified that this is because dendrites in the structure after solidification largely grow, which effects the surface where β-Sn dendrites become prominent, and the surface property becomes rough. They have also found that, in order to make the surface property excellent, Ag content is necessary, and by setting the Ag content as 3 wt% or lower, the roughness is eliminated so that an excellent surface property after reflow can be obtained.

In the present invention, based on the above findings, the composition of an solder alloy containing 2.0 to 3.0 wt% Ag, 0.3 to 1.5 wt% Cu, and the balance Sn and inevitable impurities is applied so that it becomes possible to obtain an appropriate melting point and an excellent thermal fatigue-resistant characteristic as well as to realize the surface property after reflow at the same time.

Conventionally, it is considered that 3% or higher Ag content is required for the lead-free solder alloy for the electronic part. The solder alloy used for joining the water pipes, which is disclosed in Japanese Patent Laid-open No. Sho 63-13689, is considered as unusable for the electronic part because it preferably contains 2 to 4% Cu, that is, the ductility indispensable to a joint member for the electronic part is low, and this causes a hard and brittle characteristics. In the present invention, the following has been found. By limiting the Cu content as 1.5 wt% or lower, the fatigue resistance is secured without decreasing the ductility of the solder alloy. In addition, even when the Ag content is 3.0 wt% or lower, by adding Cu at the same time, a melting point demanded by the electronic part can be obtained and the surface property of excellent quality after reflow can be also secured.

Moreover, in the present invention, it has been found that, if Bi is added to the solder alloy, the melting point can be lowered while the surface property after reflow is kept excellent. As the melting point lowers, the reflow temperature can be lowered. If 0.1 wt% Bi is added, the melting point can be lowered by approximately 1°C and, if 2.0 wt% Bi is added, the melting point can be lowered by approximately 20°C.

In the present invention, an Sn-based solder alloy is used. Sn has an characteristic of transforming at 13.2°C. If Ag and Cu in a range of the present invention are added to Sn, the transformation temperature can be lowered to some extent, but not to -10°C or lower. In a case of the Sn-based solder alloy, rupture tends to take place remarkably when Sn transforms at low temperature, and as a result, a solder electrode joint is destroyed. In a TCT test (e.g. repeated cycles of heating and cooling at -40°C to 125°C) which is conducted for evaluating a thermal fatigue-resistant characteristic of the solder electrode joint, the rupture of the solder electrode joint takes place when the solder electrode joint is in the low temperature, resulting in destroy. The solder alloy in which only Ag and Cu in the range of the present invention are added to Sn realizes the thermal fatigue-resistant characteristic almost equal to that of a conventional Sn-3.5% Ag alloy, but further improvement in thermal fatigue-resistant characteristic is demanded by an electronic member which is used under the cold climate conditions.

The present invention has been achieved by finding the fact that, by adding 0.2 to 1.5 wt% Sb to the above Sn-based solder alloy containing 2.0 to 3.0 wt% Ag, 0.3 to 1.5 wt% Cu, and 0.05 to 1.5 wt% Bi, the Sn transformation at the low temperature can be suppressed and the thermal fatigue-resistant characteristic capable of sufficiently withstanding the cold climate conditions can be realized. According to the present invention, the melting point of the solder alloy becomes 220°C or lower and excellent reflow operability can be obtained.

Although the solder alloy of the present invention contains 2.0 to 3.0 wt% Ag added thereto, the Ag content being lower than 3.0 to 6.0 wt% Ag of a conventional Sn-Ag-Cu based solder alloy, equal joint reliability can be achieved so that an economic advantage that the excellent property can be realized at a low cost is also brought about.

### Brief Description of the Drawings

Fig. 1 is a microphotograph at 30 times magnification in which a solder bump after reflow in an example 1 of the present invention in an experimental example 1 of a first embodiment is photographed;
Fig. 2 is a microphotograph at 30 times magnification in which a solder bump after reflow in a comparison example 1 in the experimental example 1 of the first embodiment is photographed;
Fig. 3 is a microphotograph at 30 times magnification in which a solder bump after reflow in a comparison example 2 in the experimental example 1 of the first embodiment is photographed;
Fig. 4 is a microphotograph at 30 times magnification in which a solder bump after reflow in a comparison example 3 in the experimental example 1 of the first embodiment is photographed; and
Fig. 5 is a schematic sectional view showing the primary structure of a semiconductor device in a third embodiment.

### Detailed Description of the Preferred Embodiments

Hereinafter preferred embodiments in which the present invention is applied will be explained in detail.

### -First Embodiment-

If the content of Ag is too low, solidus temperature (melting point) of a solder alloy rises, and a function as a solder usable at around 220°C is lost. If the Ag content is 2.0 wt% or higher, the solder has an appropriate melting point and can be utilized at around 220°C.

Further, if the content of Ag is 3.0 wt% or lower, β-dendrites are suppressed from growing after reflow, which can realize a solder bump having an excellent surface property without roughness.

When Cu is added to an Sn-Ag solder alloy, the solidus temperature (melting point) lowers if the Cu content is 1.5 wt% or lower, while the solidus temperature abruptly rises if the Cu content exceeds 1.5 wt%. Therefore, in the present invention, an upper limit of the Cu content is defined as 1.5 wt%.

In the Sn-Ag alloy, networks of Ag₃Sn intermetallic compounds are produced in the solidification structure, which improves the strength and a fatigue property of the solder. In the alloy containing only Sn-Ag, the networks of the Ag₃Sn intermetallic compounds are not sufficiently connected to each other. However, if 0.3 wt% or more Cu is added to the Sn-Ag solder alloy, ring-shaped networks of the Ag₃Sn intermetallic compounds therein become dense and the strength and the fatigue property of the solder bump are improved, which makes it possible to ensure the strength and a thermal fatigue-resistant characteristic demanded by an electronic part. Therefore, in the present invention, a lower limit of the Cu content is defined as 0.3 wt%.

As described above, in the present invention, the composition of the solder alloy containing 2.0 to 3.0 wt% Ag, 0.3 to 1.5 wt% Cu, and the balance Sn and inevitable impurities is applied as a lead-free solder alloy so that it becomes possible to obtain the appropriate melting point and to secure the excellent thermal fatigue-resistant characteristic as well as to secure the surface property after the reflow at the same time. As a result, when this solder alloy is used for a solder bump of the electronic member, the evaluation for bump formation can be made in an optical method.

A solder ball having the above composition is suitable as a solder ball for forming the solder bump. Particularly, in a fine solder ball whose diameter is 300 µm or shorter, the evaluation of a solder bump formed of a solder ball having the conventional composition is difficult to be made in the optical method. However, in a case where the solder ball according to the present invention is used, the evaluation of the solder bump in the optical method can be made because its surface property is excellent.

### -Experimental Examples-

### -Experimental Example 1-

Solder balls having a diameter of 760 µm are prepared using solder alloys having the composition shown in Table 1, put on an electrode on a substrate utilizing adhesion of flux, and heated in a reflow furnace, and surface properties of solder bumps after reflow are observed.

Light is irradiated from a light source above the substrate, the electrode on the substrate is photographed, and images of light reflected by the solder bumps are compared. If the image of light focuses only on a top of the semi-spherical bump, it is judged as acceptable, while if the image of light is dispersed all over the electrode, it is judged as bump formation failure.

### (Table 1)

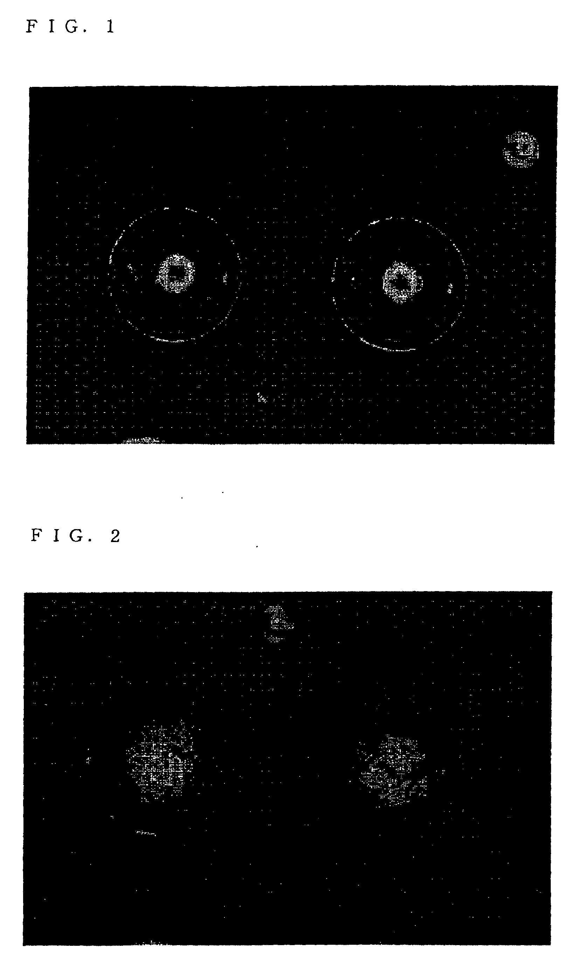

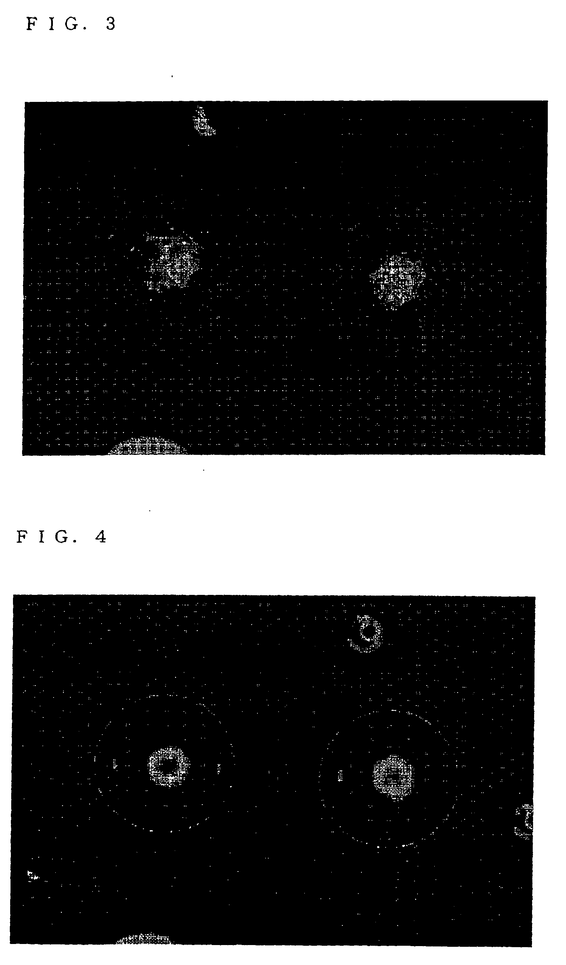

An example 1 of the present invention is a solder alloy having the composition according to the present invention, a comparison example 1 is an Sn-Ag solder alloy, a comparison example 2 is an Sn-Ag-Bi-Cu solder alloy, and a comparison example 3 is a Pb-Sn lead solder alloy. Surface properties of solder bumps after reflow in these examples are photographed and shown in Fig. 1 to Fig. 4 as photographs enlarged at 30 times magnification. Fig. 1 corresponds to the example 1 of the present invention, Fig. 2 corresponds to the comparison example 1, Fig. 3 corresponds to the comparison example 2, and Fig. 4 corresponds to the comparison example 3. In the example 1 of the present invention and the comparison example 3 (lead solder), images of light focus only on tops of the bumps, that is, excellent evaluation results have been obtained. The reason is that the surface properties after reflow are excellent. In the comparison examples 1 and 2, images of light are dispersed all over the surfaces of the bumps, that is, unacceptable evaluation results as bumps have been obtained. The reason is that the surface properties become rough after reflow and the light is reflected irregularly.

### -Experimental Example 2-

Solder balls having a diameter of 300 µm are prepared using the same solder alloys having the component shown in Table 1 as those in the experimental example 1. With the solder balls, silicon chip parts and printed boards are flip-chip connected, and temperature cycle thermal shock tests are conducted using the flip-chip connected silicon chip parts and printed boards as specimens.

The silicon chip part has 64 electrode lands, each of which has a diameter of 200 µm, arranged on a silicon chip in its circumference with spacing of 0.3 mm therebetween. The printed board is a glass-epoxy resin substrate having wiring provided on one surface thereof, and has also electrode lands in positions corresponding to the electrode lands on the silicon chip.

First of all, the above-described solder balls are put on the electrode lands of both of the silicon chip part and the printed board, and heated in the reflow furnace where the solder balls are made to reflow so that solder bumps are formed. Then, the silicon chip part and printed board having the solder bumps are made to come into contact with each other with their solder bumps, heated again in the reflow furnace where both electrode portions are joined, so that the silicon chip part and the printed board are flip-chip connected to be the specimen.

The formed specimen is heated and cooled repeatedly under the temperature cycle condition of repeating -40°C (30 minutes) and +125°C (30 minutes). The tests are conducted with temperature cycle repeated times (TCT cycle time) ranging from 100 cycles to 900 cycles at 100 cycle intervals, and the correlation to rupture occurrence ratios of the solder electrodes is checked.

The evaluation result of the rupture occurrence ratio (%) at each TCT cycle time is shown in Table 2. The specimens using the solder alloy in the example 1 of the present invention and the comparison example 1 exhibit low rupture occurrence ratios, that is, they have excellent thermal fatigue-resistant characteristics, while the specimen in the comparison example 3 (lead solder) exhibits a high rupture occurrence ratio. A fatigue-resistant characteristic of the specimen in the comparison example 2 deteriorates by approximately 20% because it contains Bi.

### (Table 2)

As explained in the experimental examples 1 and 2, when the solder alloy having the composition according to the present invention is used, the excellent results can be obtained in both terms of the surface property after reflow and the thermal fatigue-resistant characteristic.

### -Experimental Example 3-

Solder balls having a diameter of 300 µm are prepared using solder alloys having the composition shown in Table 3, solder bumps are formed in the same manner as that in the above experimental example 1, and surface properties of the solder bumps are observed. As a result, in the observation of the surfaces of the solder bumps after reflow, an extremely excellent surface property in which an image of light focuses only on a top of the semi-spherical bump is obtained in each of examples 2 to 4 of the present invention compared with a comparison example 1 and a comparison example 2.

### (Table 3)

### -Second Embodiment-

If the content of Ag is too low, the solidus temperature (melting point) of a solder alloy rises, and a function as a solder usable at around 220°C is lost. If the Ag content is 2.0 wt% or higher, the solder alloy has an appropriate melting point and can be utilized at around 220°C. Further, if the Ag content is 3.0 wt% or lower, β-dendrites are suppressed from growing after reflow, which can realize a solder bump having an excellent surface property without roughness. The Ag content is more preferably 3.0 wt% or lower.

When Cu is added to an Sn-Ag solder alloy, the solidus temperature (melting point) lowers if the Cu content is 1.5 wt% or lower, while the solidus temperature abruptly rises if the Cu content exceeds 1.5 wt%. Therefore, in the present invention, an upper limit of the Cu content is defined as 1.5 wt%.

In the Sn-Ag alloy, networks of Ag₃Sn intermetallic compounds are produced in the solidification structure, which improves the strength and a fatigue property of the solder. In the alloy containing only Sn-Ag, the networks of the Ag₃Sn intermetallic compounds are not sufficiently connected to each other. However, if 0.3 wt% or more Cu is added to the Sn-Ag solder alloy, ring-shaped networks of the Ag₃Sn intermetallic compounds therein become dense and the strength and the fatigue property of the solder bump are improved, which makes it possible to ensure the strength and a thermal fatigue-resistant characteristic demanded by an electronic part. Therefore, in the present invention, a lower limit of the Cu content is defined as 0.3 wt%.

A lower limit of the content of Bi is defined as 0.05 wt% because, if the Bi content is less than 0.05 wt%, an effect of lowering the melting point is not sufficient. Further, if the Bi content increases, the mechanical strength of the solder alloy increases while the ductility of the solder alloy decreases. Moreover, it has been found that, if the Bi content is too high, needle-shaped Bi crystals precipitate on a surface of the solder after reflow, which deteriorates the surface property. If the Bi content is 1.5 wt% or lower, the ductility of the solider alloy is excellent as well as the surface property of the solder after reflow is also excellent. Therefore, an upper limit of the Bi content is defined as 1.5 wt%. The Bi content is preferably 1.0 wt% or lower.

A lower limit of the content of Sb is defined as 0.2 wt% because an effect of suppressing Sn from transforming at low temperature is insufficient if the Sb content is lower than 0.2 wt%. An upper limit of the Sb content is defined as 1.5 wt% because, if the Sb content exceeds 1.5 wt%, the surface roughness of the solder after reflow cannot be suppressed and an effect of improving the thermal fatigue-resistant characteristic also decreases.

If the total content of Ag, Cu, Sub, and Bi exceeds 5.0 wt%, the surface after reflow becomes rough because of precipitation, oxidization, and the like of alloy elements on a ball surface and the excellent surface property cannot be obtained. Accordingly, an upper limit of the total content of Ag, Cu, Sb, and Bi is defined as 5.0 wt%.

As described above, in the present invention, the composition of the solder alloy containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower, is applied as a lead-free solder alloy, so that it becomes possible to obtain the appropriate melting point and to greatly improve the thermal fatigue-resistant characteristic as well as to secure the surface property after reflow at the same time. Consequently, when this solder alloy is used for the solder bump of the electronic member, the evaluation for bump formation can be made in the optical method. Further, even when the electronic member using the solder alloy is used in cold climates, sufficient thermal fatigue-resistant characteristic can be obtained.

A solder ball having the above-described composition is suitable as a solder ball for forming the solder bump. Particularly, in a fine solder ball whose diameter is 300 µm or shorter, the evaluation of a solder bump formed of a solder ball having the conventional composition is difficult to be made in the optical method. However, in a case where the solder ball according to the present invention is used, the evaluation of the solder bump in the optical method can be made because the surface property of the solder bump after reflow is smooth and excellent.

### -Experimental Examples-

### -Experimental Example 1-

Solder balls having a diameter of 300 µm are prepared using solder alloys having the composition shown in Table 4, put on an electrode on a substrate utilizing adhesion of flux, and heated in a reflow furnace, and the surface properties of solder bumps after reflow are observed.

Light is irradiated from a light source above the substrate, the electrode on the substrate is photographed, and images of light reflected by the solder bump are compared. If the image of light focuses only on a top of the semi-spherical bump, it is judged as acceptable, while if the image of light is dispersed all over the electrode, it is judged as bump formation failure.

### (Table 4)

Examples 1 to 4 of the present invention are solder alloys having the composition according to the present invention, a comparison example 1 is a solder alloy in which the total content of Ag, Cu, Sb, and Bi exceeds 5.0 wt%, a comparison example 2 is a solder alloy in which Sb exceeds the upper limit of the present invention and Bi is not contained, a comparison example 3 is an Sn-Ag solder alloy, a comparison example 4 is an Sn-Ag-Bi-Cu solder alloy, and a comparison example 5 is a Pb-Sn lead solder alloy. A surface property of the solder bump after reflow in each of the examples is photographed and the surface luster is evaluated. In the examples 1 to 4 of the present invention and the comparison example 5 (lead solder), images of light focus only on tops of the bumps, that is, excellent evaluation results have been obtained. The reason is that the surface properties after reflow are excellent. In the comparison examples 1 to 4, images of light are dispersed all over the surfaces of the bumps, that is, unacceptable evaluation results as bumps have been obtained. The reason is that the surface properties become rough after reflow and the light is reflected irregularly.

### -Experimental Example 2-

Solder balls having a diameter of 300 µm are prepared using the same solder alloys having the component shown in Table 4 as those in the experimental example 1. With the solder balls, silicon chip parts and printed boards are flip-chip connected, and temperature cycle thermal shock tests are conducted using the flip-chip connected silicon chip parts and printed boards as specimens.

The silicon chip part has 64 electrode lands, each of which has a diameter of 200 µm, arranged on a silicon chip in its circumference with spacing of 0.3 mm therebetween. The printed board is a glass-epoxy resin substrate having wiring provided on one surface thereof, and has also electrode lands in positions corresponding to the electrode lands on the silicon chip.

First of all, the above-described solder balls are put on the electrode lands of both of the silicon chip part and the printed board, and heated in the reflow furnace where the solder balls are made to reflow so that solder bumps are formed. Then, the silicon chip part and printed board having the solder bumps are made to come into contact with each other with their solder bumps, heated again in the reflow furnace where both electrode portions are joined, so that the silicon chip part and the printed board are flip-chip connected to be the specimen.

The formed specimen is heated and cooled repeatedly under the temperature cycle condition where -40°C (30 minutes) and +125°C (30 minutes) are repeated. The tests are conducted with temperature cycle repeated times (TCT cycle time) ranging from 100 cycles to 1100 cycles at 100 cycle intervals, and the correlation to rupture occurrence ratios of the solder electrodes is checked.

The evaluation result of the rupture occurrence ratio (%) at each TCT cycle time is shown in Table 5. It is obvious that the specimens using the solder alloys in the examples 1 to 4 of the present invention exhibit extremely low rupture occurrence ratios and are particularly excellent in thermal fatigue-resistant characteristic. The thermal fatigue-resistant characteristics in the comparison example 2 (Sb exceeding the upper limit) and the comparison example 3 (Sn-Ag) are approximately equal to those in the examples of the present invention. In the comparison example 1 and comparison example 4 (Sn-Ag-Cu-Bi), the thermal fatigue-resistant characteristics are reasonably excellent but the rupture occurrence ratios are high compared with the examples of the present invention. The comparison example 5 (lead solder) exhibits a high rupture occurrence ratio.

### (Table 5)

As explained in the experimental examples 1 and 2, when the solder alloy having the composition according to the present invention is used, the excellent result can be obtained in both terms of the surface property after reflow and the thermal fatigue-resistant characteristic.

### -Third Embodiment-

In this embodiment, an electronic member such as a semiconductor device having the solder bump disclosed in the first or second embodiment is explained as an example.

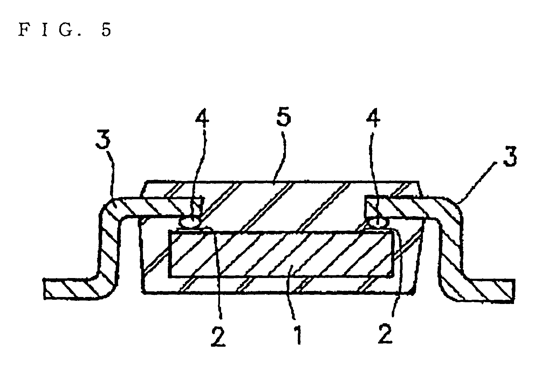

Fig. 5 is a schematic sectional view showing the primary structure of the semiconductor device of the embodiment.

This semiconductor device has the structure in which electrodes 2 of a semiconductor chip 1 and inner leads 3 are joined with solder bumps 4 formed of the lead-free solder alloy disclosed in the first or second embodiment and are molded by resin 5. In the semiconductor device, the solder bumps 4 are joined to the electrodes 2 arranged in a circumference of the semiconductor chip 1 in advance, or are joined to the inner leads 3 in advance, and the semiconductor chip 1 and the inner leads 3 are put together and joined by one operation.

According to the embodiment, in preparing the semiconductor device (electronic member), the quality of the solder bumps can be properly evaluated even if a large number of fine solder bumps are formed, and therefore the electronic member having excellent quality can be obtained. Particularly, in a case of a fine solder bump having a side length of 0.2 mm or shorter, an excellent result which cannot be realized by the solder bump having the conventional composition can be obtained. The electronic member in which plural electronic parts are joined with the solder electrodes having the above composition has excellent characteristics that it has the solder electrodes of excellent quality because the quality is properly evaluated in a preparation step, and further that the solder electrodes has a suitable thermal fatigue-resistant characteristic.

### Industrial Applicability

By using the solder alloy having the composition according to the present invention, the surface property of the solder bump after reflow becomes excellent, which makes it possible to properly judge the quality of the bump formation in the optical method. At the same time, the suitable melting point can be obtained and the excellent thermal fatigue-resistant characteristic can be realized. The solder bump can be formed using the solder ball having the composition of the present invention.

Further, the electronic member, in which the solder bump having the composition of the present invention is formed, and the electronic member, in which the electronic parts are joined with the solder electrode having the composition of the present invention, have advantages that the electrodes of high quality are formed therein without including failures and that the thermal fatigue-resistant characteristics of the electrodes are excellent.

In addition, although the solder alloy of the present invention contains 2.0 to 3.0 wt% Ag added thereto, that is, the Ag content is lower than that of the conventional solder alloy which contains similar components, joint reliability equal to that of the conventional solder alloy can be achieved so that an economic advantage that the excellent property is realized at a low cost is also brought about.

**(Table 1)**

| | SOLDER ALLOY COMPOSITION (wt%) | | | | |
|---|---|---|---|---|---|
| | Sn | Ag | Cu | Bi | Pb |
| EXAMPLE 1 OF THE PRESENT INVENTION | BALANCE | 2.6 | 0.6 | | |
| COMPARISON EXAMPLE 1 | BALANCE | 3.5 | | | |
| COMPARISON EXAMPLE 2 | BALANCE | 3.3 | 0.5 | 1.0 | |
| COMPARISON EXAMPLE 3 | 63 | | | | BALANCE |

**(Table 2)**

| | RUPTURE OCCURRENCE RATIO (%) | | | | | | | | |
|---|---|---|---|---|---|---|---|---|---|
| TCT CYCLE TIME | 100 CYCLES | 200 CYCLES | 300 CYCLES | 400 CYCLES | 500 CYCLES | 600 CYCLES | 700 CYCLES | 800 CYCLES | 900 CYCLES |
| EXAMPLE 1 OF THE PRESENT INVENTION | 0 | 0 | 4.7 | 20.3 | 46.9 | 84.8 | 88.2 | 98.7 | 100 |
| COMPARISON EXAMPLE 1 | 0 | 0 | 7.8 | 18.7 | 53.1 | 71.9 | 89.1 | 96.9 | 100 |
| COMPARISON EXAMPLE 2 | 0 | 2.0 | 7.8 | 28.1 | 82.8 | 96.9 | 100 | 100 | 100 |
| COMPARISON EXAMPLE 3 | 0 | 7.8 | 46.9 | 95.3 | 100 | 100 | 100 | 100 | 100 |

**(Table 3)**

| | SOLDER ALLOY COMPOSITION (wt%) | | | |
|---|---|---|---|---|
| | Sn | Ag | Cu | Bi |
| EXAMPLE 2 OF THE PRESENT INVENTION | BALANCE | 2.0 | 0.3 | |
| EXAMPLE 3 OF THE PRESENT INVENTION | BALANCE | 2.5 | 0.6 | |
| EXAMPLE 4 OF THE PRESENT INVENTION | BALANCE | 3.0 | 1.5 | |
| COMPARISON EXAMPLE 1 | BALANCE | 3.5 | | |
| COMPARISON EXAMPLE 2 | BALANCE | 3.3 | 0.5 | 1.0 |

**(Table 4)**

| SOLDER ALLOY COMPOSITION (wt%) | | | | | | | |
|---|---|---|---|---|---|---|---|
| EXAMPLE / ELEMENT | Sn | Ag | Cu | Bi | Sb | Pb | SURFACE LUSTER |
| EXAMPLE 1 OF THE PRESENT INVENTION | BALANCE | 2.6 | 0.6 | 0.1 | 0.5 | | ○ |
| EXAMPLE 2 OF THE PRESENT INVENTION | BALANCE | 2.6 | 0.6 | 1.0 | 0.5 | | ○ |
| EXAMPLE 3 OF THE PRESENT INVENTION | BALANCE | 2.6 | 0.6 | 0.5 | 0.5 | | ○ |
| EXAMPLE 4 OF THE PRESENT INVENTION | BALANCE | 2.6 | 0.5 | 0.5 | 1.0 | | ○ |
| COMPARISON EXAMPLE 1 | BALANCE | 2.6 | 0.6 | 1.5 | 0.5 | | × |
| COMPARISON EXAMPLE 2 | BALANCE | 2.6 | 0.6 | | 3.0 | | × |
| COMPARISON EXAMPLE 3 | BALANCE | 3.5 | | | | | × |
| COMPARISON EXAMPLE 4 | BALANCE | 3.5 | 0.5 | 1.0 | | | × |
| COMPARISON EXAMPLE 5 | 63 | | | | | BALANCE | ○ |

**(Table 5)**

| RUPTURE OCCURRENCE RATIO (%) | | | | | | | | | | | |
|---|---|---|---|---|---|---|---|---|---|---|---|
| TCT CYCLE TIME | 100 CYCLES | 200 CYCLES | 300 CYCLES | 400 CYCLES | 500 CYCLES | 600 CYCLES | 700 CYCLES | 800 CYCLES | 900 CYCLES | 1000 CYCLES | 1100 CYCLES |
| EXAMPLE 1 OF THE PRESENT INVENTION | 0 | 0 | 0 | 5.2 | 19.3 | 41.3 | 78.8 | 83.0 | 91.6 | 97.4 | 100 |
| EXAMPLE 2 OF THE PRESENT INVENTION | 0 | 0 | 0 | 6.2 | 22.2 | 47.1 | 89.1 | 91.0 | 99.7 | 100 | 100 |
| EXAMPLE 3 OF THE PRESENT INVENTION | 0 | 0 | 0 | 5.2 | 24.3 | 42.3 | 82.8 | 88.0 | 95.6 | 100 | 100 |
| EXAMPLE 4 OF THE PRESENT INVENTION | 0 | 0 | 0 | 3.2 | 12.3 | 38.9 | 57.6 | 69.6 | 82.7 | 92.7 | 100 |
| COMPARISON EXAMPLE 1 | 0 | 0 | 4.6 | 20.3 | 46.9 | 84.8 | 88.3 | 98.6 | 100 | 100 | 100 |
| COMPARISON EXAMPLE 2 | 0 | 0 | 0 | 7.2 | 14.9 | 33.1 | 57.9 | 76.2 | 88.2 | 98.1 | 100 |
| COMPARISON EXAMPLE 3 | 0 | 0 | 0 | 4.2 | 17.3 | 40.9 | 75.3 | 90.1 | 97.3 | 100 | 100 |
| COMPARISON EXAMPLE 4 | 0 | 0 | 0 | 12.3 | 34.9 | 67.3 | 88.1 | 93.7 | 100 | 100 | 100 |
| COMPARISON EXAMPLE 5 | 0 | 7.6 | 46.8 | 95.4 | 100 | 100 | 100 | 100 | 100 | 100 | 100 |

## Claims

1. A lead-free solder alloy, comprising:
2.0 to 3.0 wt % Ag, 0.3 to 1.5 wt % Cu, and the balance Sn and inevitable impurities,
wherein the lead-free solder alloy has a smooth surface property after reflow.

2. A lead-free solder alloy for a solder bump of an electronic member, comprising:
2.0 to 3.0 wt% Ag, 0.3 to 1.5 wt% Cu, and the balance Sn and inevitable impurities.

3. A lead-free solder ball for an electronic member, comprising:
2.0 to 3.0 wt% Ag, 0.3 to 1.5 wt% Cu, and the balance Sn and inevitable impurities.

4. An electronic member having solder bumps,
wherein a part or all of the solder bumps are formed of lead-free solder alloys containing 2.0 to 3.0 wt% Ag, 0.3 to 1.5 wt% Cu, and the balance Sn and inevitable impurities.

5. An electronic member in which plural electronic parts are joined with solder electrodes,
wherein a part or all of the solder electrodes are formed of lead-free solder alloys containing 2.0 to 3.0 wt% Ag, 0.3 to 1.5 wt% Cu, and the balance Sn and inevitable impurities.

6. A method for preparing solder bumps,
wherein a lead-free solder alloy containing 2.0 to 3.0 wt% Ag, 0.3 to 1.5 wt% Cu, and the balance Sn and inevitable impurities is used, and the lead-free solder alloy is subjected to reflow processing.

7. A method for manufacturing an electronic member having solder bumps,
wherein the electronic member is manufactured using lead-free solder alloys containing 2.0 to 3.0 wt% Ag, 0.3 to 1.5 wt% Cu, and the balance Sn and inevitable impurities as the solder bumps, by subjecting the lead-free solder alloys to reflow processing.

8. A method for manufacturing an electronic member in which plural electronic parts are joined with solder electrodes,
wherein a part or all of the solder electrodes are formed of lead-free solder alloys containing 2.0 to 3.0 wt% Ag, 0.3 to 1.5 wt% Cu, and the balance Sn and inevitable impurities.

9. A lead-free solder alloy, comprising:
2.0 to 3.0 wt% Ag, 0.3 to 1.5 wt% Cu, 0.05 to 1.5 wt% Bi, 0.2 to 1.5 wt% Sb, and the balance Sn and inevitable impurities,
wherein the total content of Ag, Cu, Sb, and Bi is 5.0 wt% or lower, and a surface property after reflow is smooth.

10. A lead-free solder alloy for a solder bump of an electronic member, comprising:
2.0 to 3.0 wt% Ag, 0.3 to 1.5 wt% Cu, 0.05 to 1.5 wt% Bi, 0.2 to 1.5 wt% Sb, and the balance Sn and inevitable impurities,
wherein the total content of Ag, Cu, Sb, and Bi is 5.0 wt% or lower.

11. A lead-free solder ball for an electronic member, comprising:
2.0 to 3.0 wt% Ag, 0.3 to 1.5 wt% Cu, 0.05 to 1.5 wt% Bi, 0.2 to 1.5 wt% Sb, and the balance Sn and inevitable impurities,
wherein the total content of Ag, Cu, Sb, and Bi is 5.0 wt% or lower.

12. An electronic member having solder bumps,
wherein a part or all of the solder bumps are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower.

13. An electronic member in which plural electronic parts are joined with solder electrodes,
wherein a part or all of the solder electrodes are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower.

14. A method for preparing a solder bump,
wherein a lead-free solder alloy containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower, is used, and the lead-free solder alloy is subjected to reflow processing.

15. A method for manufacturing an electronic member having solder bumps,
wherein a part or all of the solder bumps are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower.

16. A method for manufacturing an electronic member in which plural electronic parts are joined with solder electrodes,
wherein a part or all of the solder electrodes are formed of lead-free solder alloys containing 2.0 to 3.0 wt% Ag, 0.3 to 1.5 wt% Cu, 0.05 to 1.5 wt% Bi, 0.2 to 1.5 wt% Sb, and the balance Sn and inevitable impurities, in which the total content of Ag, Cu, Sb, and Bi is 5.0 wt% or lower.
